# EUROPÄISCHE PATENTSCHRIFT

(11) **EP 0 615 552 B1**
(45) Veröffentlichungstag und Bekanntmachung des Hinweises auf die Patenterteilung: **10.01.1996**
(21) Anmeldenummer: 92924544.7
(22) Anmeldetag: 30.11.1992
(51) Int. Cl.: C23C 16/50, H01J 37/32

(54) **VERFAHREN UND VORRICHTUNG ZUR HARTSTOFFBESCHICHTUNG VON SUBSTRATKÖRPERN**
PROCESS AND DEVICE FOR COATING SUBSTRATE BODIES WITH HARD SUBSTANCES
PROCEDE ET DISPOSITIF DE RECOUVREMENT DE SUBSTRATS AVEC DES SUBSTANCES DURES

(30) Priorität: 05.12.1991 DE 4140158
(43) Veröffentlichungstag der Anmeldung: 21.09.1994
(73) Patentinhaber: Widia GmbH, D-45145 Essen (DE)
(72) Erfinder: KÖNIG, Udo, D-4300 Essen 1 (DE); VAN DEN BERG, Hendrikus, NL-5925 BT Venlo-Blerick (NL); TABERSKY, Ralf, D-4250 Bottrop (DE)
(74) Vertreter: Vomberg, Friedhelm, Dipl.-Phys.
(86) Internationale Anmeldenummer: DE9201005
(87) Internationale Veröffentlichungsnummer: WO9311275

(56) Entgegenhaltungen:
- EP-A- 0 149 408
- DE-A- 3 102 174
- DE-A- 3 417 192
- DE-A- 3 433 874
- DE-C- 3 841 731

## Beschreibung

Die Erfindung betrifft ein Verfahren zur Hartstoffbeschichtung von Substratkörpern unter Anwendung eines durch eine Glimmentladung aktivierten CVD-Verfahrens bei Temperaturen oberhalb von 300° und Drücken unter 10000 Pa.

Die Erfindung betrifft ferner eine Vorrichtung zur Durchführung des genannten Verfahrens mit mindestens einem Gaseinlaß und mindestens einem mit einer Pumpe verbundenen Gasauslaß aufweisenden Reaktor, in dessen Innenraum sich ein oder mehrere Substratkörper und eine oder mehrere hierzu im Abstand angeordnete mit einer Spannungsquelle verbundene Elektrode(n) befinden.

Hochtemperaturbeschichtungsverfahren haben den Nachteil, daß Zähigkeitsverluste des aus einem Substratkörper und einer hierauf aufgetragenen Hartstoffbeschichtung bestehenden Verbundkörpers nicht immer vermieden werden können. So sind beispielsweise bei Wendeschneidplatten, die mit Titancarbid beschichtet waren, bei der Bearbeitung von hochlegierten Stählen im unterbrochenen Schnitt durchweg höhere Verschleiße dann festgestellt worden, wenn die Beschichtung mit einem Hochtemperaturverfahren bei ca. 1000°C aufgetragen worden war.Bei hinreichend niedrigen Temperaturen können solche nachteiligen Auswirkungen des Beschichtungsverfahrens auf den Grundkörper jedoch vermieden werden. Von den Beschichtungsverfahren, die bei niedrigen Temperaturen durchführbar sind, ist neben dem PVD-Verfahren das Plasma-CVD-Verfahren von Bedeutung. Überlagert man dem Reaktionsgas in einer Niederdruckglimmentladung ein Nichtgleichgewichtsplasma, so werden die in dem Gas vorhandenen Ladungsträger unter dem Einfluß des bestehenden elektrischen Feldes beschleunigt. Abhängig von der Teilchendichte bzw. dem Druck bestimmt sich auch die freie Weglänge zwischen zwei Zusammenstößen. Reicht die Teilchenenergie bei der angelegten Spannung aus, können Moleküle oder Atome zur Dissozierung oder Ionisierung angeregt werden. Hierdurch werden chemische Reaktionen möglich, die ansonsten nur bei relativ höheren Temperaturen ablaufen könnten. Die Niederdruckplasmen können prinzipiell durch Anlegen einer konstanten Gleichspannung an einem als Kathode geschalteten Werkstück, durch eine hochfrequente Wechselspannung oder durch eine gepulste Gleichspannung erzeugt werden.

Die Hochfrequenzanregung, bei der die Energie induktiv oder kapazitiv von außen in das Reaktionsgefäß eingeführt werden kann, wird zur Abscheidung von sehr reinen Schichten in der Elektrotechnik, z.B. bei Mikrochips, häufig verwendet. Da es ohne direkt mit den Substraten verbundene Elektroden arbeitet, kommt es nicht darauf an, ob der Werkstoff selbst leitend oder nichtleitend ist. Nachteiligerweise ist dieses Verfahren sehr aufwendig.

Der einfachste Weg zur Erzeugung einer Niederdruckentladung ist der, das zu beschichtende Werkstück als Kathode zu schalten und den Rezipienten bzw. dessen Wände als Anode bzw. Erdpotential zu benutzen. Die Substrattemperatur ist hierbei eine Funktion der Spannung und des Stromes.

Weiterhin kann die Gleichspannung gepulst werden, wobei die Substrattemperatur eine Funktion der Peak-Spannung sowie des Peak-Stromes als auch der Pulsdauer und Pulsfrequenz ist. Vorteilhafterweise kann bei diesem Verfahren die Beschichtungstemperatur unabhängig von den Niederdruckentladungsparametern, der Spannung und dem Strom eingestellt werden.

CVD- Reaktoren müssen im wesentlichen zwei Forderungen erfüllen: Zum einen sollen sie die gleichzeitige Beschichtung möglichst vieler Substrate ermöglichen, also eine hohe Aufnahmekapazität besitzen, zum anderen sollen Schattierungseffekte bzw. ungleichmäßige Beschichtungen vermieden werden.

Im Hinblick auf die zweite zuvor gestellte Forderung wird bereits in der DE 22 51 571 C3 vorgeschlagen, die reaktionsfähigen Gase in den Reaktor vom gesamten Randbereich des Substratträgers aus nach innen über den Substratträger und die hierauf angebrachten Substrate strömen zu lassen, wo die Gase mittig abgezogen werden. Hiermit soll eine laminare Radialströmung erzielt werden. Der Reaktor enthält eine Deckplatte, die als erste Elektrode gegenüber der Substrataufnahmeplatte als zweiter Elektrode geschaltet ist. Zur Plasmaerzeugung wird eine Hochfrequenzspannung verwendet.

In der US-A-4 909 183 wird zunächst eine evakuierbare Kammer beschrieben, in deren Mitte eine rotationsfähige Halterung für das Beschichtungssubstrat angeordnet ist. Das Substrat selbst wird von einer zylinderförmigen kathodischen Elektrode umgeben, die mit einer HF-Spannungsquelle verbunden ist. Das Substrat dient als Anode, so daß bei angelegter Spannung an der Kathode ein Niederdruckplasma entsteht. Nachteiligerweise scheidet sich der Beschichtungswerkstoff nicht nur auf dem Substrat allein ab, sondern auch auf der Kathode sowie anderen im Raum vorhandenen, das Plasma einschließenden Wänden. Hierdurch ergeben sich große Verluste an Gasen. Nachteilig sei schließlich auch, daß sich bisweilen von der Elektrode bzw. weiteren Wänden in dem Reaktorgefäß dort niedergeschlagene Beschichtungsteile lösen und auf das Werkstück fallen, wo sie unerwünschte Defekte verursachen.

Zur Abhilfe der vorgenannten Nachteile wird in der US-A-4 909 183 daher vorgeschlagen, die anodisch geschalteten Substratkörper auf einer Kreisbahn im Abstand von der Reaktorwand nebeneinander und in der Reaktormitte die mit der HF-Quelle verbundene Kathode anzuordnen. Das Reaktionsgas soll an einer Einlaßöffnung im Reaktormantel einströmen. Die Substratkörper befinden sich auf einer Vielzahl von Rotationsantrieben, die eine ausreichende Beschichtung der Substrate gewährleisten sollen.

Die US-A-4 991 542 beschreibt ebenfalls eine Reaktionskammer, in deren Mitte ein mit einer HF-Quelle verbundener Substratkörper angeordnet ist, zu dessen Seiten diametral gegenüberstehende, gleichzeitig als Gaszufuhreinrichtungen dienende Elektroden angeordnet sind. Die Elektroden sind trichterförmig aufgebaut und besitzen etwa in Form einer Dusche mehrere Gasausströmlöcher an der dem Substrat zugewandten Seite. Anstelle die Spannungsquelle mit dem Substrat bzw. dem Substrathalter zu verbinden, kann diese auch mit Gitterelektroden verbunden sein, die jeweils beldseitig zwischen dem Substrat und der gasduschenartig ausgebildeten Elektrode angeordnet sind.

Die EP-A-0 149 408 beschreibt eine Vorrichtung zur Niedertemperaturbeschichtung, die ein Gehäuse aufweist, das am Innenmantel einen Käfig aufweist, der das in dem Innenraum erzeugte Plasma magnetisch einschließen soll. Als Plasmaerreger dient ein im Käfiginnenraum angeordneter Glühfaden; die Gehäusewand stellt eine Elektrode zur Plasmaerzeugung dar.

Die DE-A-34 17 192 beschreibt eine Vorrichtung zur Bildung eines amorphen Siliciumfilmes auf einem Substrat. Zwischen dem Substratkörper und einer Gegenelektrode wird ein Plasma erzeugt, das von einer zylinderförmigen Netzstruktur umgeben wird. Diese soll verhindern, daß Radikale sich außerhalb der Netzstruktur ausbreiten. Die Netzstruktur soll von dem äußeren Umfang des zu beschichtenden Gegenstandes in einem Abstand angeordnet sein, der kürzer als die mittlere freie Weglänge der im Plasmaerzeugungsbereich befindlichen Elektronen ist.

Alle bisher beschriebenen Verfahren bzw. Vorrichtungen konnten jedoch nur unbefriedigende Ergebnisse hinsichtlich einer gleichmäßigen Beschichtung der Substratkörper liefern. Es ist daher Aufgabe der vorliegenden Erfindung, ein Verfahren und eine Vorrichtung anzugeben, welche diesen Mangel abstellen.

Die Aufgabe wird durch das im Anspruch 1 beschriebene Verfahren gelöst. Hiernach wird in einem den oder die Substratkörper allseitig umhüllenden Käfig auf der dem Substratkörper zugewandten Innenfläche ein angrenzender Glimmsaum erzeugt, während ein zur Bildung der Hartstoff-Beschichtung geeignetes reaktives Gasgemisch durch den Käfiginnenraum geleitet wird. Im wesentlichen bildet somit der zu beschichtende Substratkörper das Zentrum des Käfigs. Insbesondere wird dieses Zentrum durch einen sich kugelsymmetrisch umhüllenden Glimmsaum umgeben. Der Substratkörper ist mit der den Glimmsaum am Käfig erzeugenden Spannungsquelle elektrisch leitend verbunden, d.h., das Substrat ist auf das Kathodenpotential (des Käfigs) gelegt. Der Käfig verhindert auch eine bevorzugte Strömungsrichtung der reagierenden Gase bzw. einen bevorzugten Ort des Niederschlages der Reaktionsprodukte als Beschichtung. Durch die Käfigstruktur wird insbesondere das Problem gelöst, das Reaktionsgas über den ganzen Käfiginnenraum gleichmäßig zu verteilen.

Weitere Ausführungsformen des erfindungsgemäßen Verfahrens sind in den Ansprüchen 2 und 3 beschrieben.

Vorzugsweise wird die Glimmentladung auf den Innenflächen des Käfigs durch einen gepulsten Gleichstrom erzeugt, die insbesondere die in der DE 38 41 731 beschriebene Charakteristik aufweisen kann. Der Substratkörper wird auf Temperaturen von maximal 1100°C erhitzt, vorzugsweise sollte die Temperatur jedoch zwischen 400 bis 600°C liegen. Die eingestellten Drücke sollten mindestens 100 Pa bis 1000 Pa in dem Reaktionsgefäß betragen.

Das System zur Lösung der vorgenannten Aufgabe wird im Anspruch 4 beschrieben. Die Elektrode ist als ein den oder die Substratkörper allseitig umhüllender Käfig ausgebildet, der vorzugsweise im wesentlichen kugelförmig ist. Der Substratkörper ist mit der den Glimmsaum am Käfig erzeugenden Spannungsquelle elektrisch leitend verbunden.

Weiterbildungen der im System vorliegenden Vorrichtung sind in den Ansprüchen 5 bis 10 beschrieben.

Der Käfig besitzt nach einer konkreten Ausgestaltung der Erfindung einen Perforationsgrad von 10 bis 60 %; hierunter wird das Verhältnis der Öffnungen zur gesamten Innenfläche des Käfigs verstanden. Vorzugsweise beträgt der Perforationsgrad jedoch 30 bis 40 %. Der definierte Perforationsgrad des Käfigs hat einen Einfluß auf das Ergebnis der Beschichtung. Wird er zu klein gewählt, so wird die Einströmung des Reaktionsgases in das Käfiginnere behindert. Wird er jedoch zu groß gewählt, wird die Kathodenfläche zur Ausbildung der Glimmentladung an den Innenflächen des Käfigs relativ klein. In diesem Fall nimmt auch die Dichte der aktivierten Moleküle im Reaktionsgas ab, und als Folge davon auch die Wachstumsgeschwindigkeit der sich auf dem Substrat bildenden Hartstoffschicht.

Weiterhin hat sich als günstige Bemaßung der Käfiginnenfläche ergeben, daß das Verhältnis der mit einem Glimmsaum überzogenen Innenfläche des Käfigs zur Oberfläche des Substratkörpers oder der Gesamtoberfläche der Substratkörper größer als 4 ist. Alternativ hierzu kann das Verhältnis der perforierten Innenfläche des Käfigs zu der genannten Oberfläche bzw. der Gesamtoberfläche größer als 4 gewählt werden.

Die zu beschichtenden Flächen des oder der Substratkörper sollten mindestens 5 mm von der Käfiginnenfläche entfernt angeordnet sein, um Abschattierungen zu vermeiden. In jedem Käfig können ein oder mehrere Substrate angeordnet sein. Vorzügsweise ist die Gaszuführung bzw. sind die Gaszuführungen und/oder die in den Käfig weisender Öffnungen so gerichtet, daß dort einströmendes Gas in das Käfiginnere geleitet wird. Auch hierbei soll das in den Käfig einströmende Gas keine Vorzugsströmungsrichtung aufweisen.

Ausführungsbeispiele der Erfindung sind in den Zeichnungen dargestellt. Es zeigen
- Fig. 1 und 2: jeweils schematische Ansichten einer erfindungsgemäßen Vorrichtung und
- Fig. 3: einen Ausschnitt einer Ansicht des Käfigs.

Diese Vorrichtung besteht im wesentlichen aus einem Reaktionsgefäß 10, der als äußeres Gefäß dient und mindestens einen Gaseinlaß 11 sowie mindestens einen Gasauslaß 12 aufweist. Das Reaktionsgefäß 10 kann ggf. zusätzlich noch durch eine äußere nicht dargestellte Heizvorrichtung beheizt werden, wenn die durch die Glimmentladung freigesetzte Wärme nicht ausreicht, um den Substratkörper 14 auf eine bestimmte Temperatur zu erwärmen.

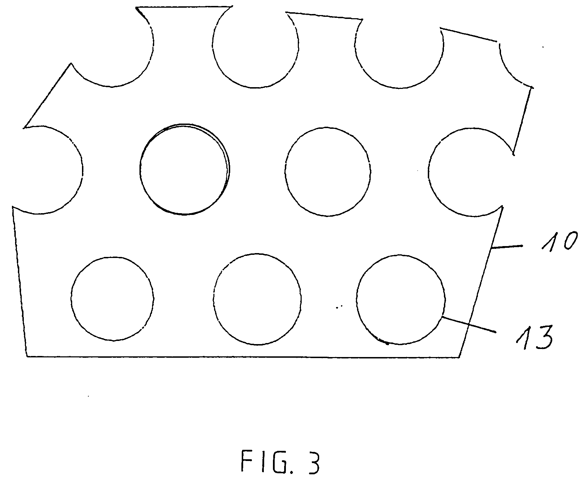

Inmitten des Reaktionsgefäßes befindet sich ein kugelförmiger Käfig 13, der den zu beschichtenden Substratkörper 14 allseitig umhüllt, jedoch über Einströmöffnungen 15 erlaubt, daß Reaktionsgase in das Käfiginnere ungehindert einströmen können. Die durch die Einströmöffnungen 15 definierte Fläche relativ zur Gesamtoberfläche des Käfigs 13 beträgt etwa 30 bis 40 %. Im vorliegenden Fall und wie in Fig. 3 anhand eines Teilstückes des Käfigs 13 dargestellt, wurde ein vorteilhafter Perforationsgrad von 33 % gewählt.

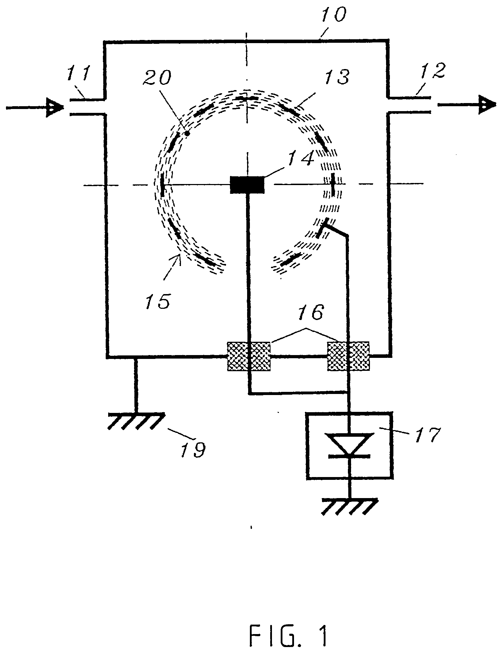

In der Ausführungsform nach Fig. 1 liegen der Substratkörper 14 und der Käfig 13 auf Kathodenpotential, wobei die entsprechenden Zuführleitungen durch Isolatoren 16 zu der Spannungsquelle 17 geführt werden. Das Reaktionsgefäß 10 liegt auf Massepotential 19 und bildet somit die Anode.

Die durch die Spannungsquelle 17 ausgegebene Spannung wird so eingestellt, daß bei fest vorgegebenem Druck ein kugelschalenförmiger Glimmsaum 20 rund um den Substratkörper entsteht, wie dies in Fig. 1 dargestellt ist. Der Vollständigkeit halber sei angemerkt, daß bei den beschriebenen Anordnungen auch an den Außenflächen der Käfige 13 ein Glimmsaum entsteht. Für die Erzielung einer gleichmäßigen Schichtdicke auf dem Substratkörper 14 ist es jedoch notwendig, daß der Glimmsaum 20 auf der Innenseite des Käfigs 13, d.h. auf der dem Substratkörper 14 zugewandten Flächen vorhanden ist.

Um mit den beschriebenen Anordnungen ausreichend hohe Schichtwachstumsraten von mehr als etwa 1 µm pro Stunde zu erhalten, sollte das Verhältnis der mit einem Glimmsaum 20 überzogenen Innenfläche des Käfigs 13 zur Oberfläche des Substratkörpers oder der Substratkörper 14 größer als 4 gewählt werden.

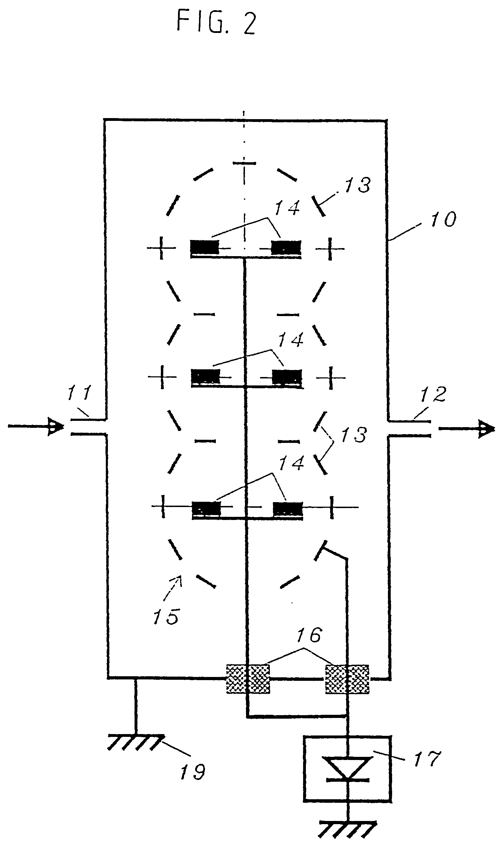

In einer weiteren Ausgestaltung der Erfindung nach Fig. 2 ist vorgesehen, daß in dem Reaktionsgefäß 10 mehrere, miteinander verbundene Käfige angeordnet sind. Dadurch kann das Aufnahmevermögen für zu beschichtende Substratkörper 14 in einfacher Weise erhöht werden. Aus Fig. 2 ist ferner ersichtlich, daß pro Käfig 13 auch mehrere neben- oder übereinander angeordnete Substratkörper 14 vorgesehen und gleichzeitig beschichtet werden können.

## Patentansprüche

1. Verfahren zur Hartstoff-Beschichtung von Substratkörpern unter Anwendung eines durch eine Glimmentladung aktivierten CVD-Verfahrens bei Temperaturen oberhalb von 300°C und Drücken unter 10000 Pa, in einem den oder die Substratkörper allseitig umhüllenden Käfig, durch dessen Innenraum ein geeignetes reaktives Gemisch geleitet wird, wobei auf der dem Substratkörper zugewandten Innenfläche des Käfigs ein Glimmsaum erzeugt wird und der Substratkörper mit der den Glimmsaum erzeugenden Spannungsquelle elektrisch leitend verbunden ist.

2. Verfahren nach Anspruch 1, dadurch gekennzeichnet, daß die Glimmentladung auf der Innenfläche des Käfigs durch einen gepulsten Gleichstrom erzeugt wird.

3. Verfahren nach einem der Ansprüche 1 oder 2, dadurch gekennzeichnet, daß der Substratkörper auf Temperaturen bis 1100°C, vorzugsweise zwischen 400 bis 600°C, erhitzt wird und/oder daß ein Druck von mindestens 100 Pa bis 1000 Pa in dem Reaktionsgefäß eingestellt wird.

4. System, bestehend aus einer Vorrichtung zur Hartstoffbeschichtung mittels eines durch eine Glimmentladung aktivierten CVD-Verfahrens und mindestens einem Substratkörper, bei dem die Vorrichtung mindestens einen Gaseinlaß (11) und mindestens einen mit einer Pumpe verbundenen Gasauslaß aufweisendes Reaktionsgefäß aufweist, in dessen Innenraum mindestens ein als Elektrode ausgebildeter und mit einer Spannungsquelle verbundener Käfig (13) angeordnet ist, der den oder die Substratkörper (14) allseitig umhüllt, wobei der oder die Substratkörper mit der den Glimmsaum am Käfig (13) erzeugenden Spannungsquelle (17) elektrisch leitend verbunden ist.

5. System nach Anspruch 4, dadurch gekennzeichnet, daß der Käfig (13) im wesentlichen kugelförmig ausgebildet ist.

6. System nach einem der Ansprüche 4 oder 5, dadurch gekennzeichnet, daß der Käfig einen Perforationsgrad, d.h. ein Verhältnis der Öffnungen zur gesamten Innenfläche des Käfigs von 10 bis 60 %, vorzugsweise von 30 bis 40 %, besitzt.

7. System nach einem der Ansprüche 4 bis 6, dadurch gekennzeichnet, daß das Verhältnis der perforierten Innenfläche des Käfigs (13) zur Oberfläche des Substratkörpers (14) oder der Substratkörper (14) größer als 4 ist oder daß das Verhältnis der mit einem Glimmsaum (20) überzogenen Innenfläche des Käfigs (13) zur Oberfläche des Substratkörpers oder der Substratkörper größer als 4 ist.

8. System nach einem der Ansprüche 4 bis 7, dadurch gekennzeichnet, daß die zu beschichtenden Flächen des oder der Substratkörper(s) (14) mindestens 5 mm, vorzugsweise 10 mm oder mehr von der Käfiginnenfläche entfernt angeordnet sind.

9. System nach einem der Ansprüche 4 bis 8, dadurch gekennzeichnet, daß in dem Reaktionsgefäß (10) mehrere, vorzugsweise miteinander verbundene Käfige (13) angeordnet sind.

10. System nach einem der Ansprüche 4 bis 9, dadurch gakennzeichnet, daß die Gaszuführung (11) und/oder die in den Käfig weisenden Öffnungen (15) so gerichtet oder angeordnet ist/sind, daß dort einströmendes Gas in das Käfiginnere geleitet wird.

## Claims

1. Process for coating of substrate bodies with hard substances by using a corona effect activated CVD-process at temperatures above 300°C and pressures below 10000 Pa, in a cage surrounding the substrate body or bodies on all sides, and through the inner space of which a suitable reactive mixture is passed whereby on the inner surface of the cage facing the substrate body a corona discharge border is produced, and the substrate body is connected electrically conductive with the voltage source producing the corona discharge border.

2. Process according to claim 1, characterized in that the corona discharge is produced on the inner surface of the cage by a pulsed direct current.

3. Process according to one of claims 1 or 2, characterized in that the substrate body is heated to temperatures up to 1100°C, preferably between 400 to 600°C and/or that a pressure of at least 100 Pa up to 1000 Pa is set in the reaction vessel.

4. System consisting of a device for the coating with hard substance by means of a corona effect activated CVD process and at least one substrate body, the device having a reaction vessel provided with at least one gas inlet (11) and at least one gas outlet connected with a pump, in the reaction vessel interior at least one cage (13) formed as an electrode and connected with a voltage source is arranged, said cage surrounds the substrate body or bodies (14) on all sides whereby the substrate body or bodies are connected electrically conductive with the voltage source (17) which produces the corona discharge border at the cage (13).

5. System according to claim 4, characterized in that the cage (13) is formed substantially spherical.

6. System according to one of claims 4 or 5, characterized in that the cage has a perforation degree, i.e. a ratio of the openings to the total inner cage surface of 10 to 60 %, preferably of 30 to 40 %.

7. System according to one of claims 4 to 6, characterized in that the ratio of the perforated inner surface of the cage (13) to the surface of the substrate body (14) or the substrate bodies (14) is higher than 4 or that the ratio of the inner surface of cage (13) covered with a corona discharge (20) to the surface of the substrate body or bodies is higher than 4.

8. System according to one of claims 4 to 7, characterized in that the surface to be coated of the substrate body or bodies (14) are arranged at a distance of at least 5 mm, preferably 10 mm or more from the inner cage surface.

9. System according to one of claims 4 to 8, characterized in that in the reaction vessel (10) several preferably interconnected cages (13) are arranged.

10. System according to one of claims 4 to 9, characterized in that the gas supply line (11) and/or the openings (15) directed towards the inside of the cage is/are oriented or arranged so that the inflowing gas is guided towards the inside of the cage.

## Revendications

1. Procédé de recouvrement de substrats avec des substances dures en application d'un procédé CVD activé par une décharge lumineuse, à des températures supérieures à 300°C et en exerçant une pression de moins de 10000 Pa, dans une cage qui enveloppe le substrat ou bien les substrats de tout côté et au travers de l'intérieur de laquelle est conduit un mélange réactif approprié, un domaine produit par décharge lumineuse étant réalisé sur la surface intérieure de la cage, qui est adjacente au substrat et le substrat étant relié de manière conductrice avec la source de tension produisant ledit domaine.

2. Procédé selon la revendication 1, caractérisé en ce que la décharge lumineuse est générée sur la surface intérieure de la cage, par un courant continu pulsé.

3. Procédé selon l'une des revendications 1 ou 2, caractérisé en ce que le substrat est chauffé à des températures allant jusqu'à 1100°C, de préférence comprises entre 400 et 600°C, et / ou qu'une pression qui est comprise entre 100 Pa et 1000 Pa du moins, est réglée dans le réacteur.

4. Système se composant d'un dispositif pour le recouvrement avec des substances dures par le biais d'un procédé CVD activé par une décharge lumineuse ainsi que du moins un substrat, dans le cas duquel le dispositif présente un réacteur présentant de sa part du moins un orifice d'admission de gaz (11) ainsi que du moins un orifice d'échappement de gaz qui est relié avec une pompe, à l'intérieur dudit réacteur étant disposée du moins une cage (13) réalisée en tant qu'électrode et reliée avec une source de tension, qui enveloppe le substrat ou bien les substrats (14) de tout côté, le substrat ou bien les substrats étant relié(s) de manière conductrice avec la source de tension (17) produisant le domaine de décharge lumineuse sur la cage (13).

5. Système selon la revendication 4, caractérisé en ce que la cage (13) présente pour l'essentiel une forme sphérique.

6. Système selon l'une des revendications 4 ou 5, caractérisé en ce que la cage présente un degré de perforation, c'est-à-dire un rapport des ouvertures à l'ensemble de la surface intérieure de la cage, qui est compris entre 10 et 60 %, et de préférence entre 30 et 40 %.

7. Système selon l'une des revendications 4 à 6, caractérisé en ce que le rapport de la surface intérieure perforée de la cage (13) à la surface du substrat (14) ou bien des substrats (14) est supérieur à 4 ou que le rapport de la surface intérieure de la cage (13), qui est recouverte d'une couche (20) produite par décharge lumineuse, à la surface du substrat ou bien des substrats est supérieur à 4.

8. Système selon l'une des revendications 4 à 7, caractérisé en ce que les surfaces à recouvrir du substrat ou bien des substrats (14) sont disposées à une distance de 5 mm du moins, et de préférence de 10 mm ou plus de la surface intérieure de la cage.

9. Système selon l'une des revendications 4 à 8, caractérisé en ce que dans le réacteur (10) sont disposées plusieurs cages (13) qui sont de préférence reliées entre elles.

10. Système selon l'une des revendications 4 à 9, caractérisé en ce que l'orifice d'admission de gaz (11) et/ou les ouvertures (15) menant dans la cage est ou bien sont orienté(es) ou disposé(es) de telle sorte que du gaz qui y est admis soit conduit vers l'intérieur de la cage.
